# EUROPEAN PATENT APPLICATION

(11) **EP 4 484 988 A1**
(43) Date of publication of application: **01.01.2025**
(21) Application number: 22928684.4
(22) Date of filing: 25.02.2022
(51) Int. Cl.: G01R 33/02

(54) **SENSOR CHIP, MAGNETIC SENSOR COMPRISING SAME, AND MAGNETIC SENSOR PRODUCTION METHOD**

(71) Applicant: TDK Corporation, Tokyo 103-6128 (JP)
(72) Inventor: ONODERA, Ikuhito, Tokyo 103-6128 (JP); HARAKAWA, Osamu, Binan, Laguna (PH)
(74) Representative: Epping - Hermann - Fischer
(86) International application number: PCT/JP2022/007962
(87) International publication number: WO 2023/162157

(57) **Abstract**

To accurately perform positioning of an external magnetic body with respect to a sensor chip. After mounting of a sensor chip 20 on a substrate 10, an external magnetic body 30 is mounted on the substrate 10 so as to overlap a magnetic layer M1 as viewed in the Y-direction perpendicular to an element formation surface 21. Further, the position of the external magnetic body 30 in the X-direction is adjusted with reference to alignment marks 60 and 61 which are provided so as to be visually confirmable from an upper surface 25 side of the sensor chip 20. Thus, in a magnetic sensor assembly, a desired positional relation can be established between the sensor chip 20 and the external magnetic body 30.

## Description

### [Technical Field]

The present invention relates to a sensor chip, a magnetic sensor having the same, and a magnetic sensor manufacturing method and, more particularly, to a sensor chip configured to detect a magnetic field collected using an external magnetic body, a magnetic sensor having such a sensor chip, and a manufacturing method for such a magnetic sensor.

### [Background Art]

Patent Document 1 discloses a magnetic sensor that uses an external magnetic body to collect magnetic flux in a sensor chip to thereby enhance detection sensitivity.

### [Citation List]

### [Patent Document]

[Patent Document 1] Japanese Patent No. 6,610,178

### [Disclosure of the Invention]

### [Problem to be Solved by the Invention]

However, when the sensor chip and external magnetic body are mounted on a substrate, it is not easy to position the external magnetic body to a desired position with respect to the sensor chip.

It is therefore an object of the present invention to provide, in a magnetic sensor assembly, a sensor chip with respect to which an external magnetic body can be accurately positioned, a magnetic sensor having such a sensor chip, and a manufacturing method for such a magnetic sensor.

### [Means for Solving the Problem]

A sensor chip according to the present invention includes: a chip main body having a mounting surface, an upper surface, and an element formation surface, the mounting surface and upper surface being positioned on the opposite sides to each other, the element formation surface being substantially perpendicular to the mounting surface and upper surface and including a lower area positioned close to the mounting surface side, an upper area positioned close to the upper surface side, and a center area positioned between the upper and lower areas; a first magnetic layer and a second magnetic layer which are provided on the center area of the element formation surface and face each other through a magnetic gap; a magnetism detection element provided on the center area of the element formation surface and positioned on a magnetic path formed by the magnetic gap; an insulating layer provided on the element formation surface and covering the magnetism detection element and first and second magnetic layers; a terminal electrode provided at a part of the surface of the insulating layer that covers the lower area of the element formation surface and connected to the magnetism detection element; and a first alignment mark embedded in a part of the insulating layer that covers the upper area of the element formation surface and visually confirmable from the upper surface. The position of the first alignment mark in the extending direction of an edge between the element formation surface and the upper surface overlaps the first magnetic layer.

According to the present invention, it is possible to adjust positional relation between the sensor chip and the external magnetic body with reference to the first alignment mark in a magnetic sensor assembly.

The sensor chip according to the present invention may further include a metal cover layer which is provided on the insulating layer so as to cover the first alignment mark. This can prevent corrosion or the like of the first alignment mark. In this case, the metal cover layer may be made of the same material as the terminal electrode. This allows the metal cover layer to be formed through the same process as that of the terminal electrode.

The sensor chip according to the present invention may further include a second alignment mark embedded in a part of the insulating layer that covers the upper area of the element formation surface and visually confirmable from the upper surface. The position of the second alignment mark in the extending direction of the edge may overlap the second magnetic layer. Thus, in a magnetic sensor assembly, it is possible to adjust positional relation between the sensor chip and another external magnetic body with reference to the second alignment mark.

In the present invention, the first alignment mark may have one end and the other end in the edge extending direction. The position of the one end of the first alignment mark in the edge extending direction may overlap the first magnetic layer, and the position of the other end of the first alignment mark in the edge extending direction may overlap the second magnetic layer. This allows the positional relation between the sensor chip and two external magnetic bodies to be adjusted with reference to the one end and the other end of the first alignment mark in a magnetic sensor assembly.

A magnetic sensor according to the present invention includes: a substrate; the above-described sensor chip which is mounted on the substrate such that the mounting surface faces the substrate; and an external magnetic body which is mounted on the substrate so as to overlap the first magnetic layer as viewed in a direction perpendicular to the element formation surface. The end face of the external magnetic body in the edge extending direction is substantially aligned with the first alignment mark. The above configuration makes it possible to provide a magnetic sensor which makes it possible to establish a desired positional relation between the sensor chip and the external magnetic body.

A magnetic sensor manufacturing method according to the present invention includes: a first step of mounting the above-described sensor chip on the substrate such that the mounting surface faces the substrate; and a second step of mounting an external magnetic body on the substrate so as to overlap the first magnetic layer as viewed in a direction perpendicular to the element formation surface. The second step includes adjusting the position of the external magnetic body in the edge extending direction with reference to the first alignment mark. Thus, in a magnetic sensor assembly, a desired positional relation can be established between the sensor chip and the external magnetic body.

### [Advantageous Effects of the Invention]

As described above, according to the present invention, there can be provided a sensor chip with respect to which an external magnetic body can be accurately positioned in a magnetic sensor assembly, a magnetic sensor having such a sensor chip, and a manufacturing method for such a magnetic sensor.

### [Brief Description of the Drawings]

[FIG. 1]

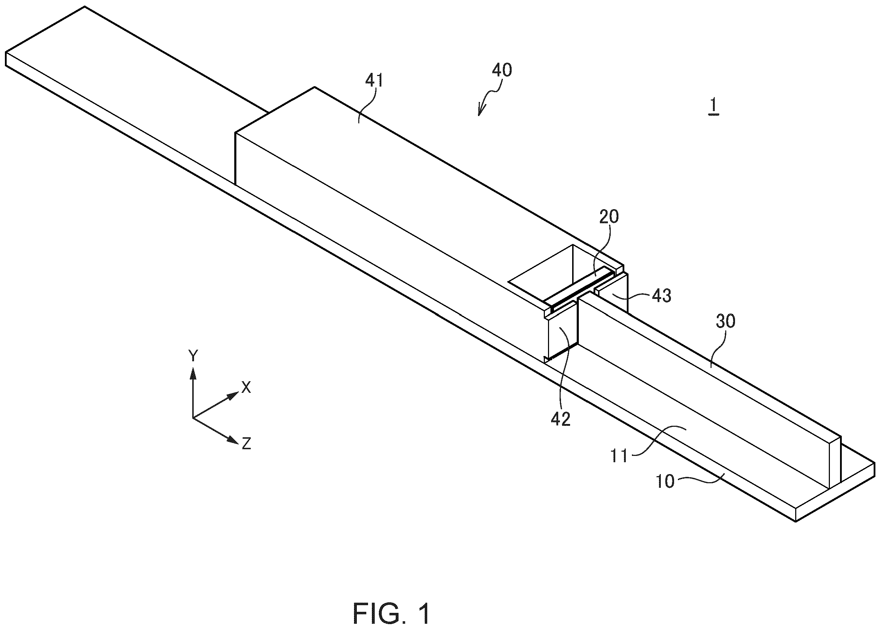

   FIG. 1 is a schematic perspective view illustrating the outer appearance of a magnetic sensor 1 according to a first embodiment of the present invention.
[FIG. 2]

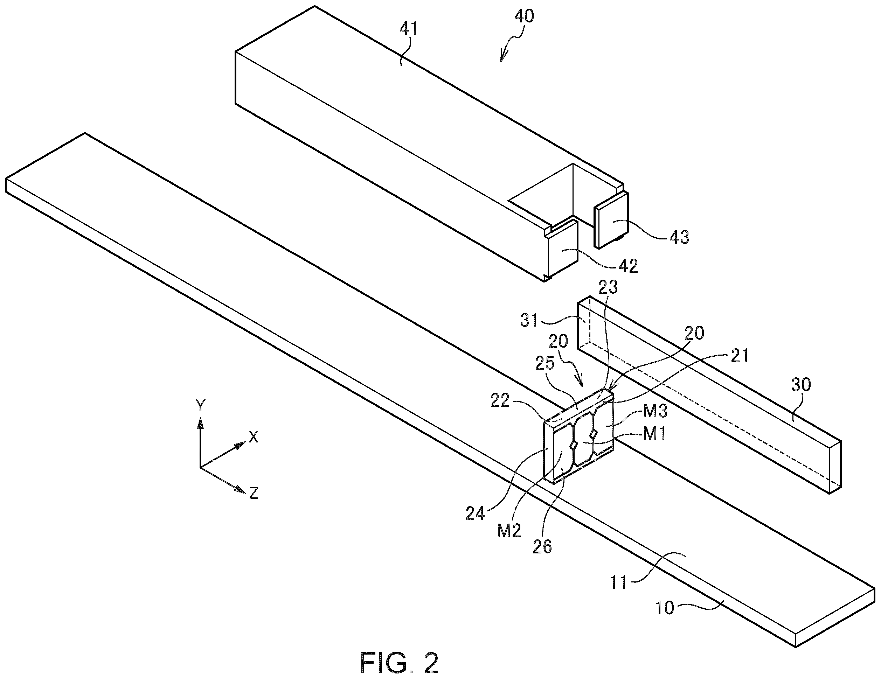

   FIG. 2 is a schematic exploded perspective view of the magnetic sensor 1.
[FIG. 3]

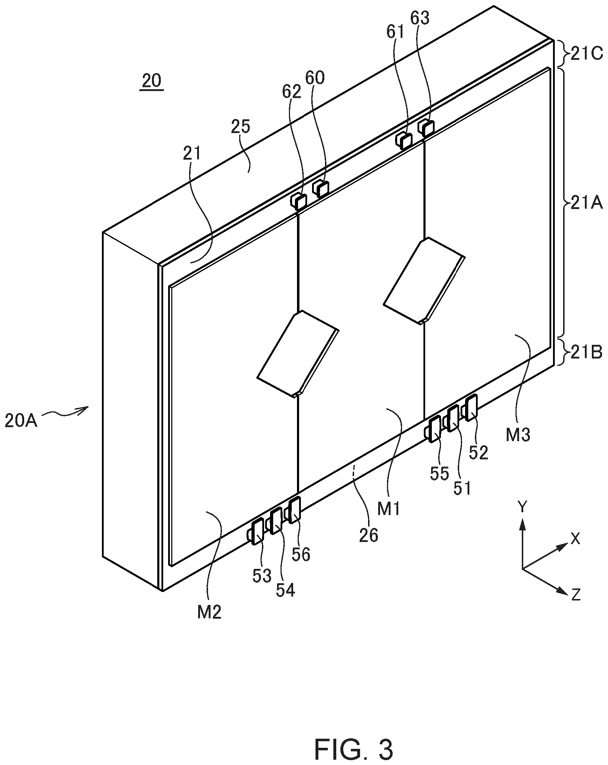

   FIG. 3 is a schematic perspective view for explaining the structure of the sensor chip 20.
[FIG. 4]

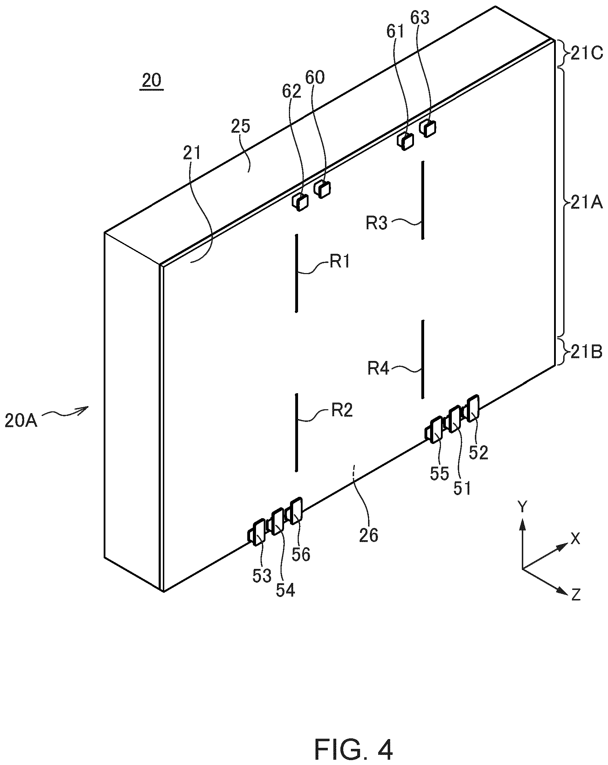

   FIG. 4 is a schematic perspective view of the sensor chip 20 from which the magnetic layers M1 to M3 have been removed.
[FIG. 5]

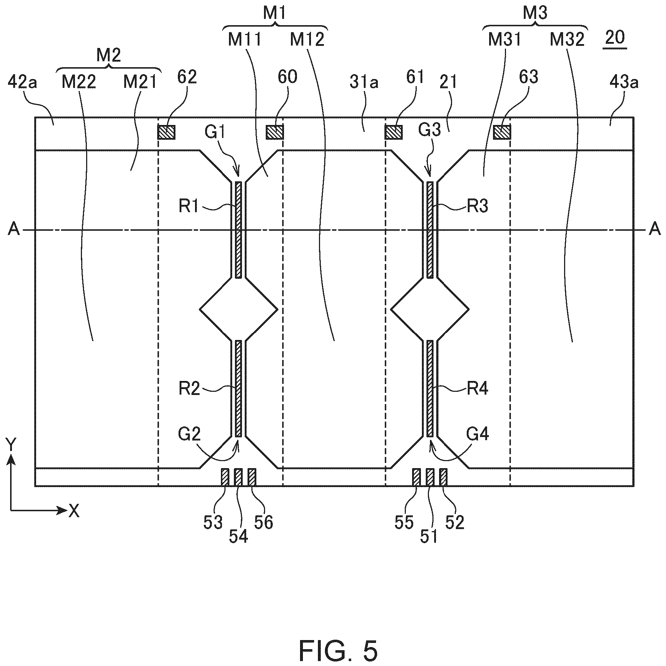

   FIG. 5 is a schematic plan view of the sensor chip 20.
[FIG. 6]

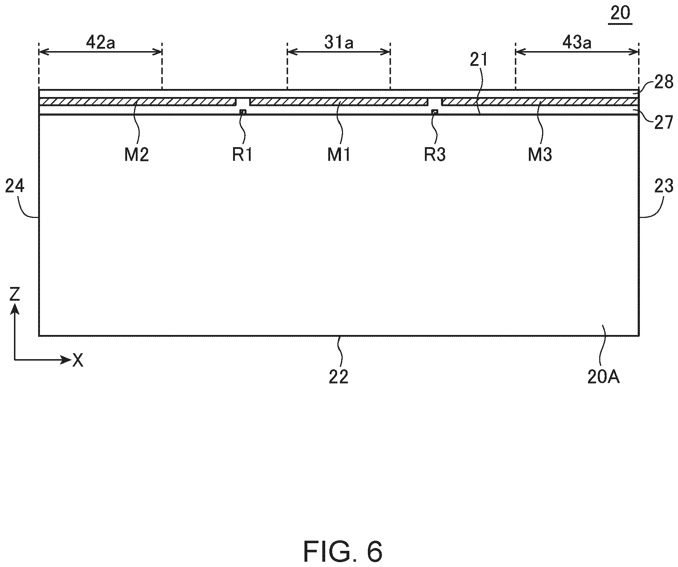

   FIG. 6 is a schematic cross-sectional view taken along the line A-A in FIG. 5.
[FIG. 7]

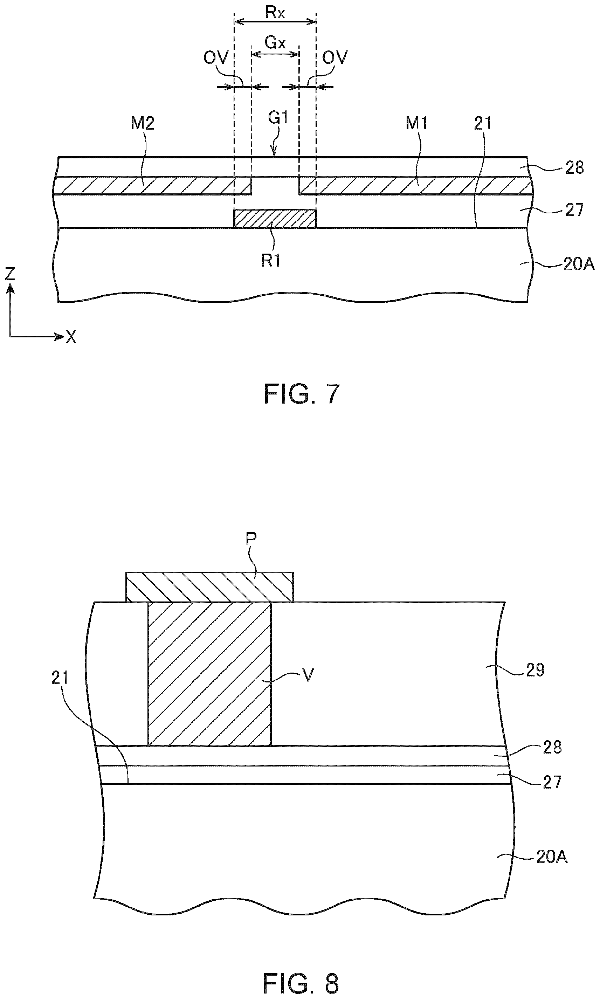

   FIG. 7 is a schematic cross-sectional view for explaining an example in which the magnetic layers and the magnetism detection overlap each other.
[FIG. 8]
   FIG. 8 is a schematic cross-sectional view for explaining the structure of the via conductor V and the metal cover layer P.
[FIG. 9]

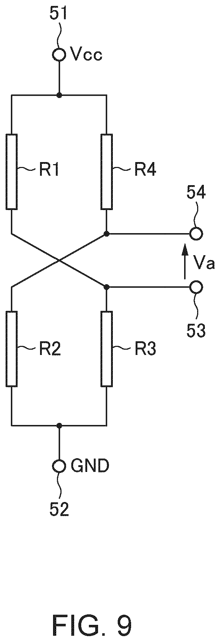

   FIG. 9 is a circuit diagram for explaining the connection relation between the magnetism detection elements R1 to R4 and the terminal electrodes 51 to 54.
[FIG. 10]

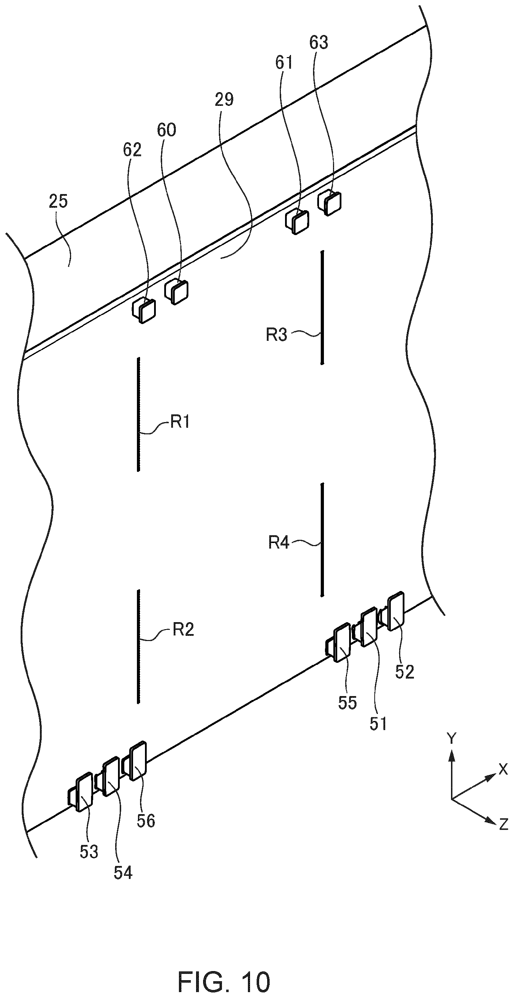

   FIG. 10 is a schematic perspective view showing the alignment marks 60 to 63 as viewed from the upper surface 25 side.
[FIG. 11]

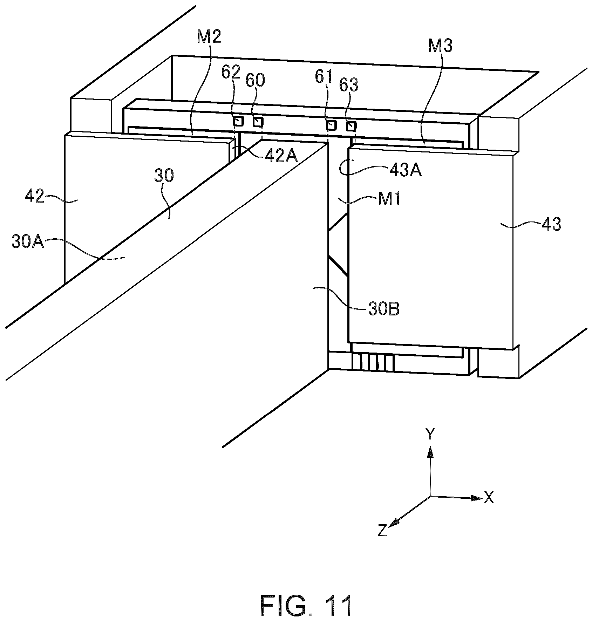

   FIG. 11 is a schematic perspective view for explaining a method of assembling the magnetic sensor 1.
[FIG. 12]

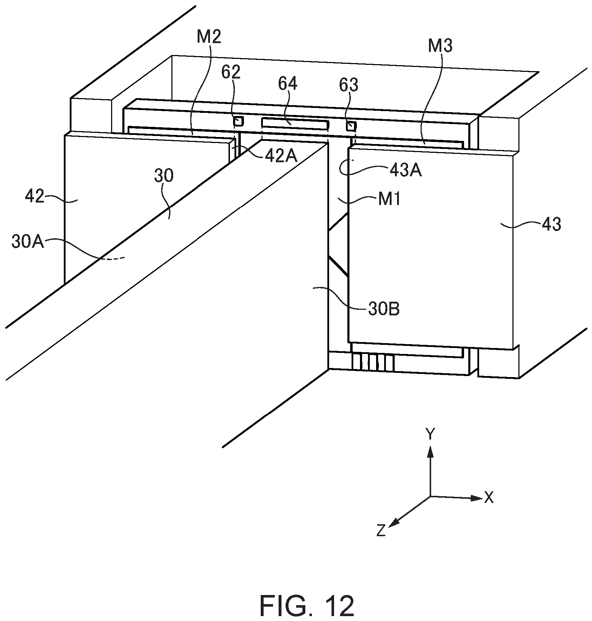

   FIG. 12 is a schematic perspective view for explaining the shape and position of the alignment mark 64 according to a modification.
[FIG. 13]

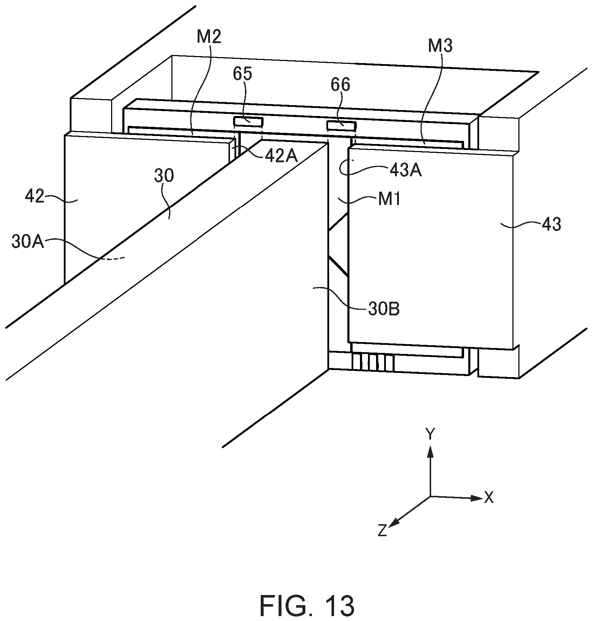

   FIG. 13 is a schematic perspective view for explaining the shape and position of the alignment marks 65 and 66.
[FIG. 14]

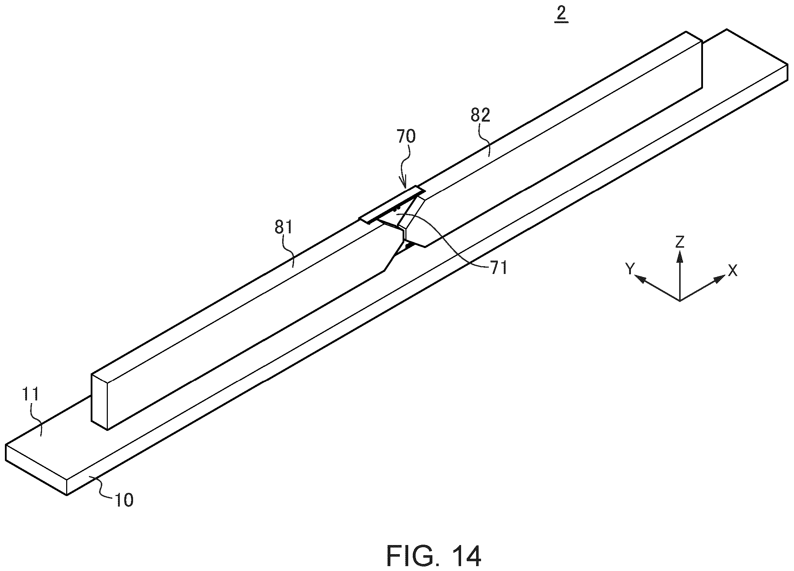

   FIG. 14 is a schematic perspective view illustrating the outer appearance of a magnetic sensor 2 according to a second embodiment of the present invention.
[FIG. 15]

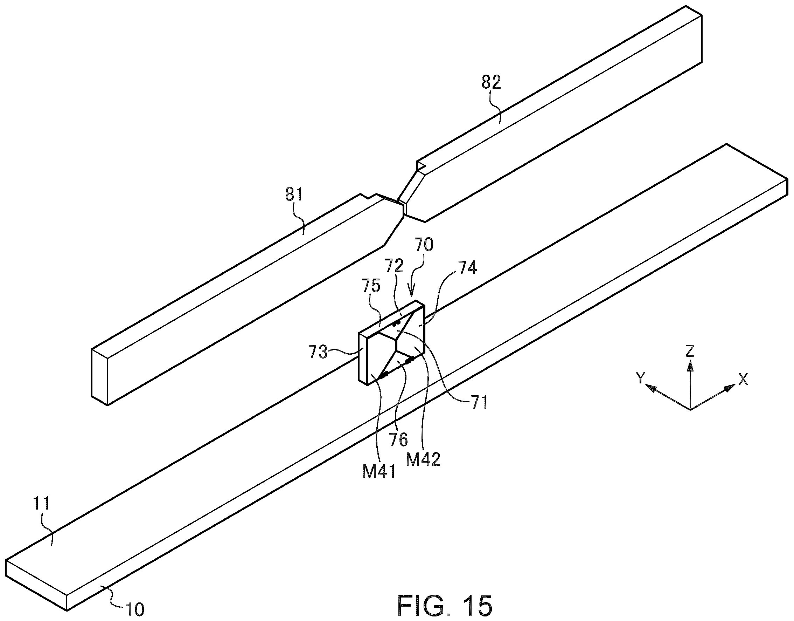

   FIG. 15 is a schematic exploded perspective view of the magnetic sensor 2.
[FIG. 16]

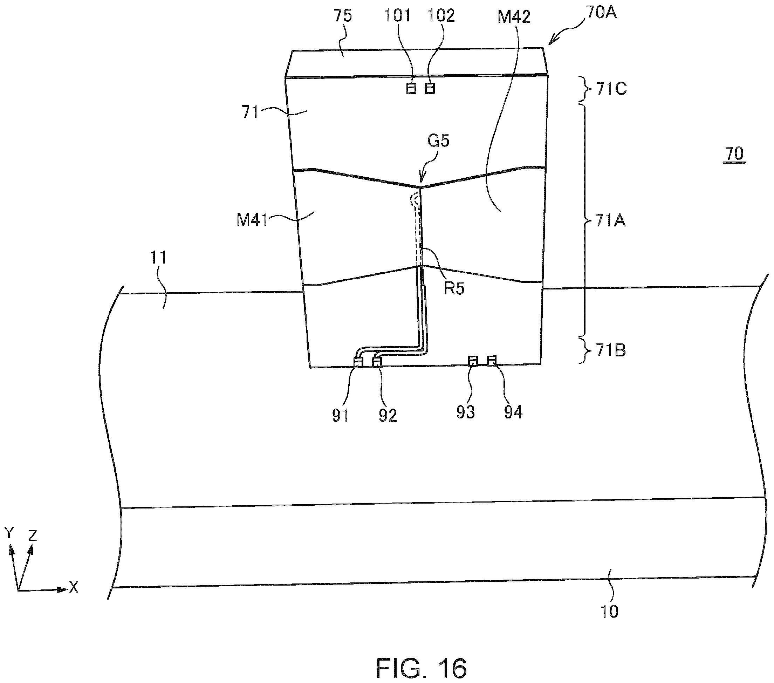

   FIG. 16 is a schematic perspective view for explaining the structure of the sensor chip 70.
[FIG. 17]

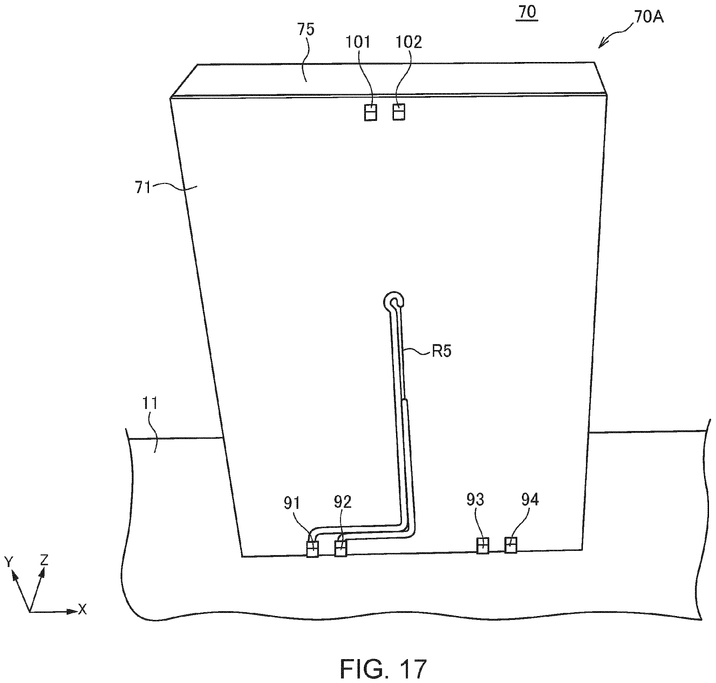

   FIG. 17 is a schematic perspective view of the sensor chip 70 from which the magnetic layers M11 and M12 have been removed.
[FIG. 18]

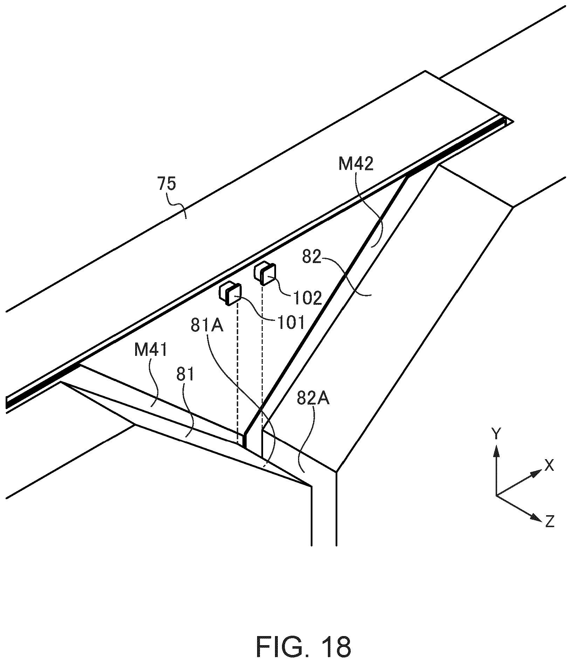

   FIG. 18 is a schematic perspective view for explaining a method of assembling the magnetic sensor 2.
[FIG. 19]

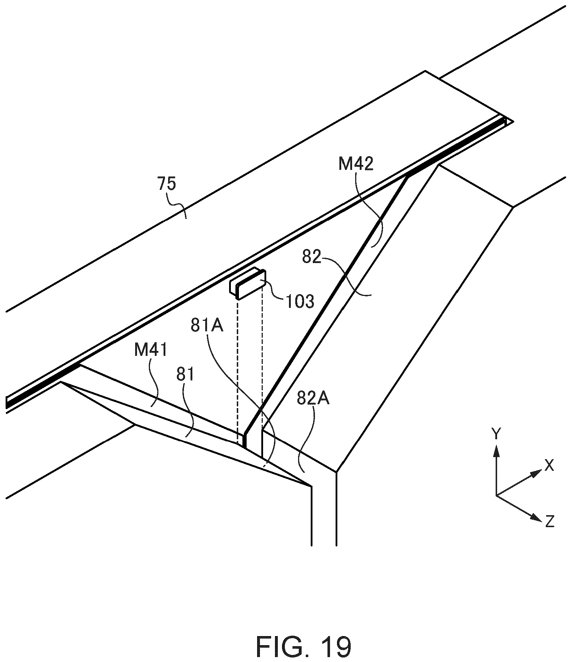

   FIG. 19 is a schematic perspective view for explaining the shape and position of the alignment mark 103 according to a modification.

### [Mode for Carrying Out the Invention]

Hereinafter, preferred embodiments of the present invention will be described in detail with reference to the accompanying drawings.

### <First Embodiment>

FIG. 1 is a schematic perspective view illustrating the outer appearance of a magnetic sensor 1 according to a first embodiment of the present invention. FIG. 2 is a schematic exploded perspective view of the magnetic sensor 1.

As illustrated in FIGS. 1 and 2, the magnetic sensor 1 according to the first embodiment includes a substrate 10, a sensor chip 20, and external magnetic bodies 30 and 40. The sensor chip 20 and external magnetic bodies 30 and 40 are mounted on a surface 11 of the substrate 10 constituting the XY surface. The sensor chip 20 has an element formation surface 21 and a back surface 22 which constitute the XY surface, side surfaces 23 and 24 which constitute the YZ surface, and an upper surface 25 and a mounting surface 26 which constitute the XZ surface. The sensor chip 20 is mounted on the substrate 10 such that the mounting surface 26 faces the surface 11 of the substrate 10. The Magnetism detection elements (to be described later) and magnetic layers M1 to M3 (also to be described later) are formed on the element formation surface 21 of the sensor chip 20. As described above, in the present embodiment, the surface 11 of the substrate 10 and the element formation surface 21 of the sensor chip 20 are perpendicular to each other; however, they need not necessarily be completely perpendicular, but the angle formed therebetween may deviate from the perpendicularity.

The external magnetic bodies 30 and 40 act to collect magnetic flux in the sensor chip 20 and are made of a high-permeability material, such as ferrite. The external magnetic body 30 has a bar-like body elongated in the Z-direction and is positioned at substantially the X-direction center of the element formation surface 21 such that an end face 31 positioned at one end in the Z-direction partially covers the magnetic layer M1. The external magnetic body 40 is positioned on the side opposite to the external magnetic body 30 with respect to the sensor chip 20. The external magnetic body 40 has a bar-like part 41 elongated in the Z-direction and covering the back surface 22 of the sensor chip 20 and overhang parts 42 and 43 protruding from the bar-like part 41 toward the element formation surface 21 side so as to respectively cover the side surfaces 23 and 24 of the sensor chip 20 and being bent so as to partially cover the magnetic layers M2 and M3. With this configuration, a magnetic field in the Z-direction is selectively collected, and the collected magnetic field is applied to the sensor chip 20.

FIG. 3 is a schematic perspective view for explaining the structure of the sensor chip 20. FIG. 4 is a schematic perspective view of the sensor chip 20 from which the magnetic layers M1 to M3 have been removed.

As illustrated in FIGS. 3 and 4, the element formation surface 21 of the sensor chip 20 belongs to a chip main body 20A and has a center area 21A positioned at the Y-direction center, a lower area 21B positioned close to the mounting surface 26 side, and an upper area 21C positioned close to the upper surface 25 side. The center area 21A is positioned between the lower area 21B and the upper area 21C. The Magnetism detection elements R1 to R4 and the magnetic layers M1 to M3 are provided on the center area 21A of the element formation surface 21. On the other hand, terminal electrodes 51 to 56 are provided on the lower area 21B of the element formation surface 21, and alignment marks 60 to 63 are provided on the upper area 21C of the element formation surface 21. The X-direction positions of the alignment marks 60 to 63 have a predetermined relation with the X-direction positions of the magnetism detection elements R1 to R4 and magnetic layers M1 to M3. The magnetism detection elements R1 to R4, magnetic layers M1 to M3, and alignment marks 60 to 63 are formed using a wafer process (thin-film process) before singulation of the sensor chip 20, so that relative positional relation can be established extremely accurately between the alignment marks 60 to 63 and the magnetism detection elements R1 to R4 and between the alignment marks 60 to 63 and the magnetic layers M1 to M3.

FIG. 5 is a schematic plan view of the sensor chip 20, and FIG. 6 is a schematic cross-sectional view taken along the line A-A in FIG. 5.

As illustrated in FIGS. 5 and 6, four magnetism detection elements R1 to R4 are formed on the element formation surface 21 of the sensor chip 20. The magnetism detection elements R1 to R4 are not particularly limited in type as long as they are elements whose electric resistance varies depending on the direction of magnetic flux and may be, for example, an MR element. The magnetism detection elements R1 to R4 have the same fixed magnetization directions (for example, positive X-direction). The magnetism detection elements R1 to R4 are embedded in an insulating layer 27 covering the chip main body 20A, and the magnetic layers M1 to M3 made of permalloy are formed on the surface of the insulating layer 27. The magnetic layers M1 to M3 are covered with an insulating layer 28. Assume that parts of the respective magnetic layers M1 to M3 that are positioned at one side (upper side in FIG. 5) in the Y-direction are defined as magnetic layers M11, M21, and M31, and parts of the respective magnetic layers M1 to M3 that are positioned at the other side (lower side in FIG. 5) in the Y-direction are defined as magnetic layers M12, M22, and M32. In this case, in a plan view (as viewed in the Z-direction), the magnetism detection element R1 is positioned between the magnetic layers M11 and M21, the magnetism detection element R2 is positioned between the magnetic layers M12 and M22, the magnetism detection element R3 is positioned between the magnetic layers M11 and M31, and the magnetism detection element R4 is positioned between the magnetic layers M12 and M32. With this configuration, magnetic fields passing through respective magnetic gaps G1 to G4 are applied respectively to the magnetism detection elements R1 to R4.

However, in the present invention, the magnetism detection elements R1 to R4 each need not be positioned between two corresponding magnetic layers but may be disposed in the vicinity of the respective magnetic gaps G1 to G4 each formed by the two magnetic layers, that is, may be respectively disposed on magnetic paths formed by the respective magnetic gaps G1 to G4. Further, the width of each of the magnetic gaps G1 to G4 need not be larger than the width of each of magnetism detection elements R1 to R4 and may be smaller than the width of each of magnetism detection elements R1 to R4. In the example illustrated in FIG. 7, a width Gx of the magnetic gap G1 in the X-direction is smaller than a width Rx of the magnetism detection element R1 in the X-direction, and thus the magnetic layers M1 and M2 have an overlap OV with the magnetism detection element R1 in the Z-direction. The positional relation between the magnetic gaps G1 to G4 and the magnetism detection elements R1 to R4 may be that illustrated in FIG. 7.

In FIGS. 5 and 6, the area designated by a reference numeral 31a is an area to be covered with the end face 31 of the external magnetic body 30, and the areas designated by reference numerals 42a and 43a are areas to be covered respectively with the overhang parts 42 and 43 of the external magnetic body 40. As illustrated in FIGS. 5 and 6, the end face 31 of the external magnetic body 30 covers the magnetic layer M1, and the overhang parts 42 and 43 of the external magnetic body 40 respectively cover the magnetic layers M2 and M3. As illustrated in FIG. 8, an insulating layer 29 made of alumina or the like is formed on the surface of the insulating layer 28. The insulating layer 29 functions as a passivation layer that covers the magnetic layers M1 to M3 and magnetism detection elements R1 to R4. The insulating layer 29 has a pillar-shaped via conductor V embedded therein and a metal cover layer P covering the via conductor V formed on the surface thereof. The via conductor V is made of a good conductor, such as Cu, and the metal cover layer P is made of a metal material having high corrosion resistance, such as Au.

FIG. 9 is a circuit diagram for explaining the connection relation between the magnetism detection elements R1 to R4 and the terminal electrodes 51 to 54.

As illustrated in FIG. 9, the magnetism detection element R1 is connected between the terminal electrodes 51 and 53, the magnetism detection element R2 is connected between terminal electrodes 52 and 54, the magnetism detection element R3 is connected between terminal electrodes 52 and 53, and the magnetism detection element R4 is connected between terminal electrodes 51 and 54. The terminal electrodes 51 to 54 are connected to not-shown land patterns formed on the substrate 10 through solder balls. The terminal electrode 51 is applied with a power supply potential Vcc, and the terminal electrode 52 is applied with a ground potential GND. Since the magnetism detection elements R1 to R4 have the same fixed magnetization direction, a difference occurs between a resistance change in the magnetism detection elements R1 and R2 which are positioned on one side as viewed from the external magnetic body 30 and a resistance change in the magnetism detection elements R3 and R4 which are positioned on the other side as viewed from the external magnetic body 30. As a result, the magnetism detection elements R1 to R4 constitute a differential bridge circuit, and a change in the electrical resistance of the magnetism detection elements R1 to R4 according to a magnetic flux density appears in the terminal electrodes 53 and 54 as a differential signal Va.

The terminal electrodes 55 and 56 are connected to a not-shown compensation coil provided on the element formation surface 21 of the sensor chip 20. The compensation coil is used for performing so-called closed-loop control by canceling a magnetic field to be applied to the magnetism detection elements R1 to R4. The terminal electrodes 51 to 56 are constituted by the metal cover layer P illustrated in FIG. 8 and connected to the magnetism detection elements R1 to R4 or compensation coil through the via conductor V and a not-shown wiring pattern.

As with the terminal electrodes 51 to 56, the alignment marks 60 to 63 are constituted by the via conductor V embedded in the insulating layer 29 and the metal cover layer P covering the via conductor V (see FIG. 10). The depth of the via conductor V constituting the alignment marks 60 to 63, i.e., the y-direction distance from the upper surface in the XZ plane of the insulating layer 29 constituting the same plane as the upper surface 25 of the chip main body 20A to the lower surface in the XZ plane of the via conductor V constituting the alignment marks 60 to 63 is 100 µm or less, for example, and the insulating layer 29 is made of a material having high light transmittance, such as alumina, thus allowing the alignment marks 60 to 63 to be visually confirmed from the upper surface of the insulating layer 29 in the XY plane.

The alignment marks 60 and 61, whose positions in the X-direction overlap the magnetic layer M1, are used as a reference for mounting the external magnetic body 30 on the substrate 10. Further, the alignment marks 62 and 63, whose positions in the X-direction overlap respectively the magnetic layers M2 and M3, are used as a reference for mounting the external magnetic body 40 on the substrate 10. The X-direction refers to the extending direction of the edge between the element formation surface 21 and the upper surface 25. The alignment marks 60 and 61 may each overlap the magnetic layer M1 over the entire width thereof in the X-direction. Alternatively, the edge of each of the alignment marks 60 and 61 may overlap the edge of the magnetic layer M1. Specifically, for example, the edge of the alignment mark 60 on the positive X-direction side may be aligned with the edge of the magnetic layer M1 in the negative X-direction side, or the edge of the alignment mark 61 on the negative X-direction side may be aligned with the edge of the magnetic layer M1 in the positive X-direction side. The same applies to the alignment marks 62 and 63.

In assembling the magnetic sensor 1 according to the present embodiment, the sensor chip 20 is first mounted on the surface 11 of the substrate 10 such that the mounting surface 26 thereof faces the surface 11 of the substrate 10, and then the external magnetic bodies 30 and 40 are mounted on the surface 11 of the substrate 10. More specifically, as illustrated in FIG. 11, when the external magnetic body 30 is mounted, it is placed on the surface 11 of the substrate 10 such that the end face 31 overlaps the magnetic layer M1, and then the position thereof in the X-direction is adjusted with reference to the alignment marks 60 and 61. In the example illustrated in FIG. 11, the end portion of the alignment mark 60 on the positive X-direction side thereof indicates the X-direction position of a YZ end face 30A of the external magnetic body 30 positioned on the negative X-direction side thereof, and the end portion of the alignment mark 61 on the negative X-direction side thereof indicates the X-direction position of a YZ end face 30B of the external magnetic body 30 positioned on the positive X-direction side thereof. When the position of the external magnetic body 30 in the X-direction is adjusted in this manner with reference to the alignment marks 60 and 61, the X-direction position of the end portion of the alignment mark 60 on the positive X-direction side thereof is substantially aligned with the X-direction position of the end face 30A of the external magnetic body 30, and the X-direction position of the end portion of the alignment mark 61 on the negative X-direction side thereof is substantially aligned with the X-direction position of the end face 30B of the external magnetic body 30.

Similarly, when the external magnetic body 40 is mounted, it is placed on the surface 11 of the substrate 10 such that the overhang parts 42 and 43 respectively overlap the magnetic layers M2 and M3, and then the position thereof in the X-direction is adjusted with reference to the alignment marks 62 and 63. In the example illustrated in FIG. 11, the end portion of the alignment mark 62 on the negative X-direction side thereof indicates the X-direction position of a YZ end face 42A of the overhang part 42 positioned on the positive X-direction side thereof, and the end portion of the alignment mark 63 on the positive X-direction side thereof indicates the X-direction position of a YZ end face 43A of the overhang part 43 positioned on the negative X-direction side thereof. When the position of the external magnetic body 40 in the X-direction is adjusted in this manner with reference to the alignment marks 62 and 63, the X-direction position of the end portion of the alignment mark 62 on the negative X-direction side thereof is substantially aligned with the X-direction position of the end face 42A of the overhang part 42, and the X-direction position of the end portion of the alignment mark 63 on the positive X-direction side thereof is substantially aligned with the X-direction position of the end face 43A of the overhang part 43.

As described above, in the present embodiment, the sensor chip 20 has the alignment marks 60 to 63, thereby allowing positioning between the sensor chip 20 and the external magnetic bodies 30 and 40 in the X-direction to be performed accurately. In addition, the alignment marks 60 to 63 are constituted by the via conductor V embedded in the insulating layer 29. This allows the alignment marks 60 to 63 to be visually confirmed from the upper surface 25 side when the sensor chip 20 is vertically erected on the substrate 10 such that the element formation surface 21 is substantially perpendicular to the surface 11 of the substrate 10, thereby making it easy to perform positioning of the external magnetic bodies 30 and 40 with reference to the alignment marks 60 to 63. In addition, the alignment marks 60 to 63 and the terminal electrodes 51 to 56 have the same structure and are formed through the same process, eliminating the need to add a new process for forming the alignment marks 60 to 63. Further, the via conductor V constituting the alignment marks 60 to 63 is covered with the metal cover layer P, so that it can be prevented from being corroded even when being made of Cu or the like.

In the above embodiment, the two alignment marks 60 and 61 are used for alignment of the external magnetic body 30, and the two alignment marks 62 and 63 are used for alignment of the external magnetic body 40; however, this is not essential in the present invention. For example, one of the alignment marks 60 and 61 may be omitted, and one of the alignment marks 62 and 63 may be omitted. Further, as illustrated in FIG. 12, an alignment mark 64 obtained by integrating the alignment marks 60 and 61 may be used for alignment of the external magnetic body 30. The alignment mark 64 illustrated in FIG. 12 overlaps, in the X-direction, the magnetic layer M1 including the X-direction both ends thereof, wherein the end portion of the alignment mark 64 on the negative X-direction side indicates the X-direction position of the YZ end face 30A of the external magnetic body 30, and the end portion of the alignment mark 64 on the positive X-direction side indicates the X-direction position of the YZ end face 30B of the external magnetic body 30.

Alternatively, as illustrated in FIG. 13, an alignment mark 65 obtained by integrating the alignment marks 60 and 62 and an alignment mark 66 obtained by integrating the alignment marks 61 and 63 may be used for alignment of the external magnetic bodies 30 and 40. In this case, one end and the other end in the X-direction of the alignment mark 65 respectively overlaps, in the X-direction, the magnetic layers M1 and M2, wherein the end portion of the alignment mark 65 on the positive X-direction side indicates the X-direction position of the YZ end face 30A of the external magnetic body 30, and the end portion of the alignment mark 65 on the negative X-direction side indicates the X-direction position of the YZ end face 42A of the overhang part 42. Further, one end and the other end in the X-direction of the alignment mark 66 respectively overlaps, in the X-direction, the magnetic layers M1 and M3, wherein the end portion of the alignment mark 66 on the negative X-direction side indicates the X-direction position of the YZ end face 30B of the external magnetic body 30, and the end portion of the alignment mark 66 on the positive X-direction side indicates the X-direction position of the YZ end face 43A of the overhang part 43.

### <Second Embodiment>

FIG. 14 is a schematic perspective view illustrating the outer appearance of a magnetic sensor 2 according to a second embodiment of the present invention. FIG. 15 is a schematic exploded perspective view of the magnetic sensor 2.

As illustrated in FIGS. 14 and 15, the magnetic sensor 2 according to the second embodiment includes the substrate 10, a sensor chip 70, and external magnetic bodies 81 and 82. The sensor chip 70 and external magnetic bodies 81 and 82 are mounted on the surface 11 of the substrate 10 constituting the XZ surface. The sensor chip 70 has an element formation surface 71 and a back surface 72 which constitute the XY surface, side surfaces 73 and 74 which constitute the YZ surface, and an upper surface 75 and a mounting surface 76 which constitute the XZ surface. The sensor chip 70 is mounted on the substrate 10 such that the mounting surface 76 faces the surface 11 of the substrate 10. magnetism detection elements (to be described later) and magnetic layers M41 and M42 (also to be described later) are formed on the element formation surface 71 of the sensor chip 70.

The external magnetic bodies 81 and 82 act to collect magnetic flux in the sensor chip 70 and are made of a high-permeability material, such as ferrite. The external magnetic bodies 81 and 82 each have a plate-like body elongated in the X-direction. The external magnetic body 81 covers a part of the magnetic layer M41, and the external magnetic body 82 covers a part of the magnetic layer M42.

FIG. 16 is a schematic perspective view for explaining the structure of the sensor chip 70. FIG. 17 is a schematic perspective view of the sensor chip 70 from which the magnetic layers M11 and M12 have been removed.

As illustrated in FIGS. 16 and 17, the element formation surface 71 of the sensor chip 70 belongs to a chip main body 70A and has a center area 71A positioned at the Y-direction center, a lower area 71B positioned close to the mounting surface 76 side, and an upper area 71C positioned close to the upper surface 75 side. The center area 71A is positioned between the lower area 71B and the upper area 71C. A magnetism detection element R5 and the magnetic layers M41 and M42 are provided on the center area 71A of the element formation surface 71. On the other hand, terminal electrodes 91 to 94 are provided on the lower area 71B of the element formation surface 71, and alignment marks 101 and 102 are provided on the upper area 71C of the element formation surface 71. The alignment marks 101 and 102 have the same structure as the above-described alignment marks 60 to 63 and can be visually confirmed from the upper surface 75 side when the sensor chip 70 is vertically erected on the substrate 10. The X-direction positions of the alignment marks 101 and 102 have a predetermined relation with the X-direction positions of the magnetism detection element R5 and magnetic layers M41 and M42.

The magnetism detection element R5 is positioned so as to overlap, in a plan view (as viewed in the Z-direction) the magnetic gap G5 formed between the magnetic layers M41 and M42. With this configuration, a magnetic field in the X-direction is selectively collected, and the collected magnetic field is applied to the magnetism detection element R5. The magnetism detection element R5 extends in the Y-direction on the element formation surface 71, and one end and the other end thereof are connected respectively to the terminal electrodes 91 and 92. The terminal electrodes 93 and 94 are connected to a not-shown compensation coil.

The alignment mark 101, whose position in the X-direction overlaps the magnetic layer M41, is used as a reference for mounting the external magnetic body 81 on the substrate 10. Further, the alignment mark 102, whose position in the X-direction overlaps the magnetic layer M42, is used as a reference for mounting the external magnetic body 82 on the substrate 10.

In assembling the magnetic sensor 2 according to the present embodiment, the sensor chip 70 is first mounted on the surface 11 of the substrate 10 such that the mounting surface 76 thereof faces the surface 11 of the substrate 10, and then the external magnetic bodies 81 and 82 are mounted on the surface 11 of the substrate 10. More specifically, as illustrated in FIG. 18, when the external magnetic body 81 is mounted, it is placed on the surface 11 of the substrate 10 so as to overlap the magnetic layer M41, and then the position thereof in the X-direction is adjusted with reference to the alignment mark 101. Similarly, when the external magnetic body 82 is mounted, it is placed on the surface 11 of the substrate 10 so as to overlap the magnetic layer M42, and then the position thereof in the X-direction is adjusted with reference to the alignment mark 102.

In the example illustrated in FIG. 18, the end portion of the alignment mark 101 on the positive X-direction side thereof indicates the X-direction position of a YZ end face 81A of the external magnetic body 81 positioned on the positive X-direction side thereof. When the position of the external magnetic body 81 in the X-direction is adjusted in this manner with reference to the alignment mark 101, the X-direction position of the end portion of the alignment mark 101 on the positive X-direction side thereof is substantially aligned with the X-direction position of the end face 81A of the external magnetic body 81. Similarly, the end portion of the alignment mark 102 on the negative X-direction side thereof indicates the X-direction position of a YZ end face 82A of the external magnetic body 82 positioned on the negative X-direction side thereof. When the position of the external magnetic body 82 in the X-direction is adjusted in this manner with reference to the alignment mark 102, the X-direction position of the end portion of the alignment mark 102 on the negative X-direction side thereof is substantially aligned with the X-direction position of the end face 82A of the external magnetic body 82.

As described above, in the present embodiment as well, the sensor chip 70 has the alignment marks 101 and 102, thereby allowing positioning between the sensor chip 70 and the external magnetic bodies 81 and 82 in the X-direction to be performed accurately.

In the above embodiment, the alignment marks 101 and 102 are respectively used for alignment of the external magnetic bodies 81 and 82; however, this is not essential in the present invention. For example, as illustrated in FIG. 19, an alignment mark 103 obtained by integrating the alignment marks 101 and 102 may be used for alignment of the external magnetic bodies 81 and 82. one end and the other end of the alignment mark 103 in the X-direction illustrated in FIG. 19 respectively overlaps, in the X-direction, the magnetic layers M41 and M42, wherein the end portion of the alignment mark 103 on the negative X-direction side indicates the X-direction position of the YZ end face 81A of the external magnetic body 81, and the end portion of the alignment mark 103 on the positive X-direction side indicates the X-direction position of the YZ end face 82A of the external magnetic body 82.

While the preferred embodiment of the present disclosure has been described, the present disclosure is not limited to the above embodiment, and various modifications may be made within the scope of the present disclosure, and all such modifications are included in the present disclosure.

### [Reference Signs List]

1, 2 magnetic sensor
10 substrate
11 surface of substrate
20, 70 sensor chip
20A, 70A chip main body
21, 71 element formation surface
21A, 71A center area
21B, 71B lower area
21C, 71C upper area
22, 72 back surface of sensor chip
23, 24, 73, 74 side surface of sensor chip
25, 75 upper surface of sensor chip
26, 76 mounting surface of sensor chip
27-29 insulating layer
30, 40, 81, 82 external magnetic body
30A, 30B, 31, 42A, 43A, 81A, 82A end face
31a, 42a, 43a, area covered with external magnetic body
41 bar-like part
42, 43 overhang part
42A, 43A end face
51-56, 91-94 terminal electrode
60-66, 101-103 alignment mark
G1-G5magnetic gap
M1-M3, M11, M12, M21, M22, M31, M32, M41, M42 magnetic layer
P metal cover layer
R1-R5magnetism detection element
V via conductor

## Claims

1. A sensor chip comprising:
a chip main body having mounting surface and an upper surface positioned on an opposite sides to each other, and an element formation surface substantially perpendicular to the mounting surface and upper surface and including a lower area positioned close to the mounting surface side, an upper area positioned close to the upper surface side, and a center area positioned between the upper area and the lower area;
first and second magnetic layers provided on the center area of the element formation surface and face each other through a magnetic gap;
a magnetism detection element provided on the center area of the element formation surface and positioned on a magnetic path formed by the magnetic gap;
an insulating layer provided on the element formation surface and covering the magnetism detection element and first and second magnetic layers;
a terminal electrode provided at a part of a surface of the insulating layer that covers the lower area of the element formation surface and connected to the magnetism detection element; and
a first alignment mark embedded in a part of the insulating layer that covers the upper area of the element formation surface and visually confirmable from the upper surface,
wherein a position of the first alignment mark in an extending direction of an edge between the element formation surface and the upper surface overlaps the first magnetic layer.

2. The sensor chip as claimed in claim 1, further comprising a metal cover layer provided on the insulating layer so as to cover the first alignment mark.

3. The sensor chip as claimed in claim 2, wherein the metal cover layer is made of a same material as the terminal electrode.

4. The sensor chip as claimed in any one of claims 1 to 3, further comprising a second alignment mark embedded in a part of the insulating layer that covers the upper area of the element formation surface and visually confirmable from the upper surface,
wherein a position of the second alignment mark in the extending direction of the edge overlaps the second magnetic layer.

5. The sensor chip as claimed in any one of claims 1 to 3,
wherein the first alignment mark has one end and other end in the extending direction of the edge,
wherein a position of the one end of the first alignment mark in the extending direction of the edge overlaps the first magnetic layer, and
wherein a position of the other end of the first alignment mark in the extending direction of the edge overlaps the second magnetic layer.

6. A magnetic sensor comprising:
a substrate;
the sensor chip as claimed in any one of claims 1 to 5 which is mounted on the substrate such that the mounting surface faces the substrate; and
an external magnetic body mounted on the substrate so as to overlap the first magnetic layer as viewed in a direction perpendicular to the element formation surface,
wherein an end face of the external magnetic body in the extending direction of the edge is substantially aligned with the first alignment mark.

7. A method of manufacturing a magnetic sensor, the method comprising:
a first step of mounting the sensor chip as claimed in any one of claims 1 to 5 on a substrate such that the mounting surface faces the substrate; and
a second step of mounting an external magnetic body on the substrate so as to overlap the first magnetic layer as viewed in a direction perpendicular to the element formation surface,
wherein the second step includes adjusting a position of the external magnetic body in the extending direction of the edge with reference to the first alignment mark.
